# EUROPÄISCHE PATENTSCHRIFT

(11) **EP 2 848 107 B1**
(45) Veröffentlichungstag und Bekanntmachung des Hinweises auf die Patenterteilung: **01.06.2016**
(21) Anmeldenummer: 13722287.3
(22) Anmeldetag: 08.05.2013
(51) Int. Cl.: H05K 13/04

(54) **VORRICHTUNG ZUM BESTÜCKEN VON SUBSTRATEN MIT ELEKTRISCHEN BAUELEMENTEN**
DEVICE FOR FITTING ELECTRICAL COMPONENTS ON SUBSTRATES
DISPOSITIF DE MONTAGE DE COMPOSANTS ELECTRIQUES SUR DES SUBSTRATS

(30) Priorität: 11.05.2012 DE 102012009439
(43) Veröffentlichungstag der Anmeldung: 18.03.2015
(73) Patentinhaber: MIMOT GmbH, 79539 Lörrach (DE)
(72) Erfinder: MEHDIANPOUR, Mohamed, 81829 München (DE); PHILIPP, Jürgen, 79639 Grenzach-Whylen (DE)
(74) Vertreter: Müller Hoffmann & Partner
(86) Internationale Anmeldenummer: PCT/EP2013/001379
(87) Internationale Veröffentlichungsnummer: WO 2013/167276

(56) Entgegenhaltungen:
- WO-A1-2008/056721
- DE-B3- 10 336 609
- DE-C1- 10 016 130

## Beschreibung

Erfindung bezieht sich auf eine Vorrichtung zum Bestücken von Substraten mit elektrischen Bauelementen mit mindestens einem Bestückkopf zum Handhaben der Bauelemente,
wobei das Substrat in einem Bestückbereich der Vorrichtung fixierbar ist,
wobei der Bestückkopf in einer linearen Längsführung eines Führungsarms verschiebbar ist, der in einer Querrichtung an einem Grundkörper der Vorrichtung verschiebbar ist.

Eine derartige Vorrichtung ist durch die US6568069 B1 bekannt geworden. Bei diesem üblichen Aufbau ist die maximale Verschiebelänge des Bestückkopfs in der Längsrichtung auf die Länge der Linearführung des Führungsarms minus die Führungslänge des Bestückkopfes beschränkt. Die Erstreckung der Vorrichtung in der Längsrichtung wird zusätzlich durch Fußteile des Führungsarms, die Auflage des Führungsarms auf dem Grundkörper sowie durch Rahmenteile des Grundkörpers bestimmt, so dass die Arbeitslänge der Vorrichtung im Verhältnis zu deren Gesamtlänge entsprechend verkürzt ist.

Die DE 100 16 130 C1 zeigt, dass ein Bestückkopf an einem Führungsarm teleskopartig so angelagert sein kann, dass er über dessen Ende geringfügig hinausgreifen und auf entsprechend eng benachbarte Abholbereiche zugreifen kann.

Die DE 103 36 609 B3 zeigt einen Positionierarm, welcher an seiner Oberseite in einer Querführung des Maschinenchassis geführt ist. Die Längsführung des Bestückarms für den Bestückkopf befindet sich auf einer Längsseite des Führungsarms.

Die WO 2008/056721 A1 zeigt einen üblichen XY-Roboter mit einer linearen Querführung für den Führungsarm, wobei an diesem eine lineare Längsführung für den Bestückarm ausgebildet ist.

Die Substrate werden in einer üblicherweise linearen Transportstrecke durch die Vorrichtung transportiert und beim Bestücken in einem z.B. zentralen Bestückbereich der Vorrichtung fixiert. Stationäre Abholstellen der Bauelemente verschiedenen Typs sind entlang zumindest einer Längsseite der Transportstrecke aneinander gereiht, wobei an jeder Abholstelle Bauelemente gleichen Typs zuführbar sind. Der Führungsarm erstreckt sich in der Transportrichtung der Substrate und ist in der Querrichtung derart verschiebbar, dass der Bestückkopf zwischen den Abholstellen der Bauelemente und den Bestückpositionen auf dem Substrat verfahrbar ist. Die maximale Anzahl der im Zugriffsbereich des Bestückkopfs liegenden Abholstellen ist somit durch die Verschiebelänge des Bestückkopfes am Führungsarm bestimmt.

Der Erfindung liegt die Aufgabe zugrunde, bei gleichbleibendem Grundaufbau den Arbeitsbereich der der Vorrichtung zu vergrößern und insbesondere die Anzahl der gleichzeitig bereitstellbaren Bauelementetypen zu erhöhen.

Diese Aufgabe wird durch die im Kennzeichen des Anspruchs 1 angegebenen Merkmale gelöst.

Durch das zusätzlich anbringbare stationäre Führungselement ist es möglich, die Vorrichtung mit geringem Änderungsaufwand unterschiedlichen Anforderungen anzupassen. Es versteht sich, dass zum Bestückkopf führende Verbindungskabel entsprechend verlängert sind. In dem zusätzlich gewonnenen Verschiebebereich des Bestückkopfs können z.B. zusätzliche Funktionselemente wie wechselbare Pipetten zum Ansaugen unterschiedlicher Bauelemente an den Bestückkopf angeordnet werden.

Insbesondere können zusätzliche Bauelemente an zusätzlichen Abholstellen vorgehalten werden, womit sich die Anzahl der gleichzeitig bereitstellbaren Bauelemente entsprechend erhöht. Es versteht sich, dass in dem zusätzlichen Abholbereich seltener benötigte Bauelemente angeordnet werden. Falls die benötigte Anzahl der Bauelementetypen hinreichend gering ist, können die betroffenen Abholstellen innerhalb des Verschiebebereichs des Bestückkopfes am Führungsarm angeordnet werden. Die Vorrichtung kann dann auch ohne das Führungselement betrieben werden, das z.B. an einer anderen Vorrichtung verwendet werden kann.

Das Führungselement kann z.B. zumindest eine lineare stationäre Führungsschiene einer standardisierten Linearführung sein, die unmittelbar am Grundkörper der Vorrichtung gelagert ist. Es kann aber auch als am Grundkörper gelagertes Tragteil ausgebildet sein, an dem eine solche Führungsschiene befestigt ist.

Vorteilhafte Weiterbildungen der Erfindung ergeben sich aus den in den Ansprüchen 2 bis 20 gekennzeichneten Merkmalen.

Die Lagerungselemente nach Anspruch 2 wirken z.B. mit entsprechenden Gegenlagerungselementen des Führungselementes zusammen, das somit ohne hohen Anpassungsaufwand an der Vorrichtung in einer definierten Lage angebracht werden kann.

Die Halteposition des Führungsarms lässt sich infolge verschiedener Einflüsse wie Reibung und Temperatur nicht mit absoluter Genauigkeit wiederholen. Die Weiterbildung nach Anspruch 3 ermöglicht eine genaue Anpassung und Ausrichtung des Führungselementes an die jeweilige Halteposition des Führungsarms. Als Führungsbahnen dienen z.B. eine lineare schienenartige Längsführung am Führungsarm sowie ein dazu fluchtendes Längsführungsstück gleichen Typs am Führungselement. Dadurch ist es möglich, dass der Bestückkopf glatt zwischen den beiden Teilen verschoben werden kann. Durch eine Punktlagerung des Führungsteils am Grundkörper kann sich dieses auch in seiner Kippstellung um seine Längsachse genau an den Führungsarm anpassen.

Die weiteren Abholstellen nach Anspruch 4 sind in einem Randbereich der Vorrichtung vorzugsweise mit den anderen Abholstellen fluchtend angeordnet, so dass bei einem Bestückkopf mit einer Vielzahl von Bauelementhaltern die Abholvorgänge in einem Zug durchgeführt werden können. Es ist üblich, die Abholstellen an schmalen Zuführmodulen für die gegurteten Bauelemente auszubilden und auf einer tischartigen Bereitstelleinrichtung zusammenzufassen, die z.B. am Grundkörper zentriert wird.

Durch die Weiterbildung nach Anspruch 5 können die stationären Magnetteile in kontinuierlicher Reihung auf Führungsarm und dem Führungselement angeordnet werden, so dass über beide Teile eine durchgehende Antriebsstrecke gebildet ist. Da die Zuordnung der Magnetteile zum Spulenteil keine hohe Genauigkeit erfordert, ist es auch möglich, die Magnetteile unabhängig von der Linearführung bzw. vom Führungselement anzuordnen.

Das am Grundkörper gelagerte Führungsteil nach Anspruch 6 verlängert mit geringem Änderungsaufwand die Verschiebestrecke des Bestückkopfes bis in den äußersten Randbereich der Vorrichtung.

Durch die Weiterbildung nach Anspruch den Ansprüchen 7 bis 9 ist es möglich, alle z.B. an den Zuführmodulen ausgebildeten Abholstellen auf einer Bereitstelleinrichtung zusammenzufassen, die sich über den Führungsarm und das Führungselement erstreckt. Es ist aber auch möglich, die Abholstellen auf mehrere Bereitstelleinrichtungen zu verteilen, die nebeneinander mittel- oder unmittelbar am Grundkörper bzw. am Trägerteil fixiert sind.

Durch die Weiterbildung nach Anspruch 10 kann die Verschiebestrecke des Bestückkopfs bis in die beiden Eckbereiche der Vorrichtung verlängert werden.

Durch die Weiterbildung nach Anspruch 11 kann der Bestückkopf in seiner Abhollage ungehindert von irgendwelchen Konstruktionsteilen z.B. des Grundkörpers verfahren.

Die zusätzlichen Abholstellen nach Anspruch 12 ermöglichen die Bereitstellung von zusätzlichen Bauelementen, die dem weiteren Bestückkopf nach Anspruch 13 zugänglich sind, der zwischen den zusätzlichen Abholstellen und dem Substrat verfahrbar ist.

Durch die Weiterbildung nach Anspruch 14 kann die Verschiebestrecke des zusätzlichen Bestückkopfs bis in die betreffenden Eckbereiche der Vorrichtung verlängert werden.

Durch das angesetzte erste Trägerteil nach Anspruch 15 kann an der Vorrichtung ein entsprechend längeres Führungselement gelagert werden, das die Verschiebestrecke des Bestückkopfs noch weiter verlängert, wobei die Lagerelemente auf den Grundkörper und auf das Trägerteil verteilt sein können.

Die an den Zuführmodulen ausgebildeten Abholstellen können z.B. je nach der Größe der Bauelemente eine unterschiedliche Mittellage aufweisen. Der in der Querrichtung am Bestückkopf verschiebbare Greifer nach Anspruch 16 kann sich diesen Querabweichungen der Abholstellen anpassen.

Der Modus der Weiterbildung nach Anspruch 17 vermeidet den Anschlag des Führungsarms am Führungselement und wird vor allem dann angewendet, wenn nur Bauelemente benötigt werden, die innerhalb des Verschiebebereichs des Bestückkopfes am Führungsarm angeordnet sind. Der entsprechend vergrößerte Abstand des Bestückkopfes von den Abholstellen kann durch den quer bewegbaren Greifer kompensiert werden.

Das aerostatische Lager nach Anspruch 18 kann schmale Spalte und geringe Unebenheiten der Führungsbahn ausgleichen.

Das Fächenmagazin nach Anspruch 19 kann z.B. anstelle einer der tischartigen Bereitstelleinrichtungen an die Vorrichtung angesetzt werden.

Die Vorrichtungen nach Anspruch 20 erreichen eine besonders hohe Bestückleistung. Dadurch, dass die Bestückköpfe beider Vorrichtungen auf gleiche Abholstellen zugreifen können, wird die Prozesssicherheit erhöht, indem beim Ausfall eines Bestückkopfes der andere Kopf die entsprechenden Bauelemente bestücken kann.

Ausführungsbeispiele der Erfindung sind in der Zeichnung dargestellt und werden im folgenden näher erläutert. Es zeigen:
- Figur 1: eine perspektivische Ansicht einer Vorrichtung zum Bestücken von Substraten mit elektrischen Bauelementen,
- Figur 2: eine vergrößerte Draufsicht auf die Einzelheit A in Figur 1
- Figur 3: eine Draufsicht auf eine modifizierte Vorrichtung nach Figur 1
- Figur 4: eine weiter modifizierte Vorrichtung nach Figur 3
- Figur 5: eine weiter modifizierte Vorrichtung nach Figur 3
- Figur 6: eine weiter modifizierte Vorrichtung nach Figur 3

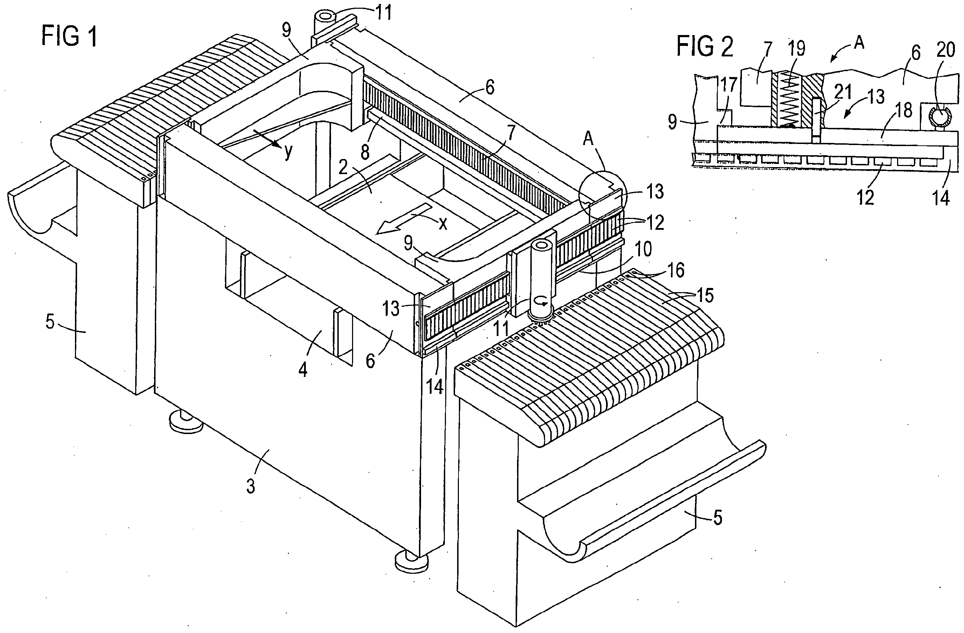

Nach Figur 1 weist eine Vorrichtung zum Bestücken von Substraten 2 mit elektrischen Bauelementen einen Grundkörper 3 auf, an dem eine waagerechte lineare Transportstrecke 4 für die Substrate 2 angebracht ist, die gemäß dem gezeigten Richtungspfeil x durch die Vorrichtung verschiebbar sind und die in einem Bestückbereich der Vorrichtung auf der Transportstrecke 4 in der gezeigten Position fixierbar sind. Die Transportrichtung der Substrate stellt eine Längsrichtung x der Vorrichtung dar. Die Bauelemente sind von Bereitstelleinrichtungen 5 abholbar, die in nicht näher dargestellter Weise wechselbar an den Grundkörper angedockt sind.

Der Grundkörper weist oberhalb der Transportstrecke in deren Endabschnitten 4 länglich gestreckte Rahmenteile 6 auf, die sich quer zur Längsrichtung x erstrecken. Die zueinander parallelen Rahmenteile 6 sind auf den einander zugewandten Innenseiten mit Antriebs- und Führungsmitteln 7 und 8 für jeweils einen sich im wesentlichen in der Längsrichtung x erstreckenden Führungsarm 9 versehen, der in einer waagerechten Querrichtung y senkrecht zur Längsrichtung x verschiebbar ist. Der Führungsarm 9 weist auf seiner der Transportstrecke 4 abgewandten flachen Außenseite eine schienenartige lineare Längsführung 10 für einen in der Längsrichtung waagerecht verschiebbaren Bestückkopf 11 zum Handhaben der Bauelemente auf. Der Verschiebeweg des Führungsarms 9 in der Querrichtung y ist so groß, dass der Bestückkopf 11 zwischen dem Bestückbereich und einer der Bereitstelleinrichtungen 5 verfahrbar ist, die nahe dem Endbereich dieses Verschiebewegs angeordnet ist.

Der Bestückkopf ist mittels eines elektrische Linearmotors verschiebbar, dessen Magnetteile 12 in der Längsrichtung x am Führungsarm 9 aneinander gereiht sind und dessen Spulenteil dem Bestückkopf 11 zugeordnet ist. Dieser ist in nicht näher dargestellter Weise mit mehreren zueinander parallelen, zylindrisch verteilten, in sich drehbaren Haltern zum Aufnehmen und Absetzen der Bauelemente versehen. Die Halter sind in senkrechter Richtung verschiebbar in einem Rotor gelagert sind, der um eine senkrechte Mittelachse drehbar ist.

An den Stirnenden der Rahmenteile 6 sind stationäre plattenartige Führungselemente 13 gelagert. Der Führungsarm 9 ist in eine Halteposition verschoben, in der seine flache Außenseite mit Außenseiten der Führungselemente 13 fluchtet. Auf diesen Außenseiten sind in der fluchtenden Verlängerung der Längsführung 10 Längsführungsstücke 14 befestigt. Die Reihe der Magnetteile 12 setzt sich ebenfalls auf Führungselemente 13 fort. Dadurch kann der Bestückkopf nicht nur auf dem Führungsarm, sondern auch auf die Führungselemente verschoben werden, wodurch sich sein Verschiebeweg entsprechend verlängert.

Die Bereitstelleinrichtung 5 ist mit flachen senkrecht stehenden Zuführmodulen 15 versehen, die in der Längsrichtung x aneinander gereiht sind. Die Zuführmodule können mit in Gurtspulen gespeicherten Bauelementen versehen werden, die zu Abholstellen 16 auf der Oberseite der Zuführmodule transportiert werden, wo sie vom Bestückkopf entnommen werden können. Die in der Längsrichtung aneinander gereihten Abholstellen 16 befinden sich in den dem Führungsarm 9 zugewandten Endabschnitten der Zuführmodule 15 im Zugriffsbereich der Halter des Bestückkopfs 11. Die Bereitstelleinrichtung 5 ist so lang , dass sich die Reihe der Zuführmodule 15 bis in den Bereich der Führungselemente13 erstreckt, so dass auch die äußersten Abholstellen 16 im Zugriffsbereich des Bestückkopfes 11 liegen, der bis an das freie Ende des jeweiligen Führungselementes verschoben ist. Die Anzahl der Abholstellen kann somit entsprechend der Länge der Führungselemente 13 erhöht werden.

Durch die Drehbarkeit des Rotors des Bestückkopfs 11 können die Halter genau auf jedes an der Abholstelle bereitliegende Bauelement ausgerichtet werden. Durch die Drehbarkeit der Halter um ihre eigene Achse ist es nach dem Abholen möglich, die Bauelemente genau in die auf dem Substrat vorgegebene Winkellage zu drehen.

Die beiden baugleichen Führungsarme 9 sind um eine senkrechte Achse drehsymmetrisch angeordnet, so dass ihre beiden flachen Außenseiten der Transportstrecke 4 abgewandt sind. Die Rahmenteile 6 sind jeweils an beiden Enden mit den Führungselementen 13 versehen, auf die jeweils die Bestückköpfe 11der beiden Führungsarme verschoben werden können. Die beiden Bereitstelleinrichtungen befinden sich auf den einander abgewandten Längsseiten der Vorrichtung, so dass an beiden Seiten die vergrößerte Anzahl der Abholstellen angeordnet werden kann.

Figur 2 zeigt eine vergrößerte Draufsicht auf das Führungselement 13 mit dem angrenzenden Endabschnitt des Führungsarms 9. Dieser ist mit einem das Führungselement 13 hintergreifenden Vorsprung 17 versehen, der um genau die Dicke einer Grundplatte 18 des Führungselements 13 an der dem Rahmenteil 6 zugewandten Innenseite des Führungselementes 13 anschlägt, das mittels einer Zugfeder 19 gegen das Rahmenteil 6 gezogen wird. Die Grundplatte 18 ist an ihrem dem Führungsarm 9 abgewandten Ende mittels eines Lagerungselementes 20 am Rahmenteil 6 allseitig schwenkbar gelagert. Ein am Rahmenteil 6 vorstehender Stift 21 greift spielarm in eine entsprechende Querbohrung des Führungselements 13 ein und sichert dessen waagerechte Orientierung.

Nach dem Aufsetzen des Vorsprungs 17 auf das Führungselement13 kann der Führungsarm 9 um eine minimale Strecke in die strichpunktiert angedeutete Stellung weiter verschoben werden, wobei das Führungselement 13 vom Rahmenteil 6 abhebt und sich über seine gesamte Höhe genau an den Vorsprung 17 anlegt. Damit sind die Außenseiten des Führungsarms und der Grundplatte und damit auch die daran angebrachte Längsführung 10 und das Längsführungsstück 14 genau aufeinander abgestimmt. Der Bestückkopf 11 kann nun ungehindert zwischen dem Führungsarm 9 und dem Führungselement 13 verschoben werden.

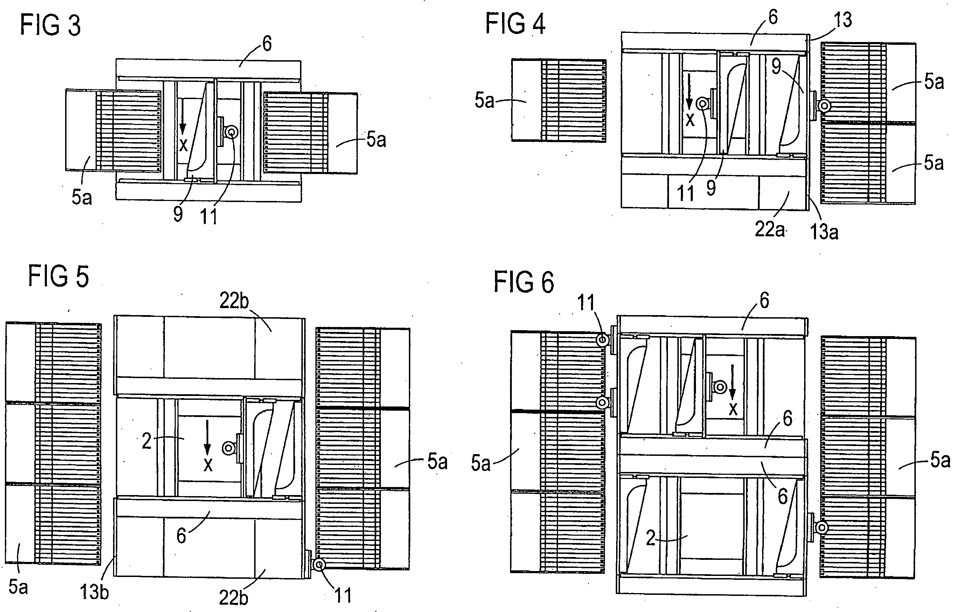

Figur 3 zeigt die Vorrichtung ohne die Führungselemente , mit nur einem Führungsarm 9 und mit um die Länge der Führungselemente verkürzten Bereitstelleinrichtungen 5a, die eine entsprechend verringerte Anzahl der Zuführmodule 15 aufweisen. Die Bereitstelleinrichtungen 5a passen nun zwischen die Rahmenteile 6 und sind somit näher an den Bestückbereich herangerückt, wodurch sich die Abholwege entsprechend verkürzen. Der Führungsarm 9 ist soweit quer verschiebbar, dass der Bestückkopf 11 die Abholstellen 16 beider Bereitstelleinrichtungen 5a erreichen kann.

Figur 4 zeigt eine andere Variante 1 der Vorrichtung mit einem in der Längsrichtung an den Grundkörper 2 und/oder das Rahmenteil 6 angesetzten Trägerteil 22a, an dem ein verlängertes Führungselement 13a gelagert ist. Am gegenüberliegenden Rahmenteil 6 ist auf derselben Längsseite eines der kurzen Führungselemente 13 gelagert. Die Verschiebelänge des Bestückkopfes in der Abholstellung ist nun so groß, dass auf dieser Seite zwei der kürzeren Bereitstelleinrichtungen 5a nebeneinander angeordnet werden können, bei denen alle Abholstellen 15 erreichbar sind.

Auf der gegenüberliegenden Längsseite der Vorrichtung sind keine der Führungselemente angebracht, sodass hier nur eine der kürzeren Bereitstelleinrichtungen 5a angeordnet ist, die vom zweiten Führungsarm 9 erreicht wird. Würde man diesen weglassen, könnte diese Bereitstelleinrichtung 5a wie nach Figur 4 näher an den Bestückbereich herangerückt werden.

Nach Figur 5 sind bei einer weiteren Variante auf beiden Querseiten der Vorrichtung in der Längsrichtung vergrößerte Trägerteile 22b an die Vorrichtung angesetzt an denen an beiden Längsseiten noch weiter verlängerte Führungselemente 13 b gelagert sind. Dadurch ist es möglich, an beiden Längsseiten der Vorrichtung mit den beiden Bestückköpfen 11 auf je drei der kürzeren Bereitstelleinrichtungen 5a zuzugreifen.

Nach Figur 6 sind zwei der Vorrichtungen ohne die Trägerteile in der Längsrichtung x unmittelbar aneinander gereiht und in definierter Weise lösbar fest miteinander verbunden und zueinander ausgerichtet. Sämtliche Stirnseiten aller Rahmenteile 6 sind mit den kurzen Führungselementen 13 versehen. Auf den beiden Längsseiten der Vorrichtung sind je drei der kurzen Bereitstelleinrichtungen 5a angeordnet. Die mittlere davon ist von den Bestückköpfen 11 beider Vorrichtungen erreichbar. Bei den auf der linken Seite angeordneten Bereitstelleinrichtungen 5a ist einer der Bestückköpfe 11 sogar in den Bereich der anderen Vorrichtung verschoben und kann z.B. beim Ausfall des anderen Bestückkopfs 11 auf dieser Seite die fehlenden Bauelemente auf dem Substrat 2 in der anderen Vorrichtung bestücken.

### Bezugszeichen

- 2: Substrat
- 3: Grundkörper
- 4: Transportstrecke
- 5, 5a: Bereitstelleinrichtung
- 6: Rahmenteil
- 7: Antriebsmittel
- 8: Führungsmittel
- 9: Führungsarm
- 10: Längsführung
- 11: Bestückkopf
- 12: Magnetteil
- 13, 13a, 13b: Führungselement
- 14: Längsführungsstück
- 15: Zuführmodul
- 16: Abholstelle
- 17: Vorsprung
- 18: Grundplatte
- 19: Zugfeder
- 20: Lagerungselement
- 21: Stift
- 22a, 22b: Trägerteil

## Patentansprüche

1. Vorrichtung zum Bestücken eines Substrats (2) mit elektrischen und Bauelementen mit mindestens einem Bestückkopf (11) zum Handhaben der Bauelemente,
wobei das Substrat (2) in einem Bestückbereich der Vorrichtung fixierbar ist, wobei der Bestückkopf (11) in einer linearen schienenartigen Längsführung (10) eines Führungsarms (9) verschiebbar ist, der in einer Querrichtung (y) an einem Grundkörper (3) der Vorrichtung verschiebbar ist,
**dadurch gekennzeichnet,**
**dass** der Führungsarm (9) in eine definierte Halteposition verschiebbar ist, dass in der fluchtenden linearen Verlängerung der Längsführung (10) des in der Halteposition befindlichen Führungsarms (9) mindestens ein mit der linearen schienenartigen Langsführung (10) fluchtendes Längsführungsstück (14) gleichen Typs für den Bestückkopf(11) unmittebar am Grundkörper oder an einem am Grundkörper gelagerten Tragteil befestigt ist und
**dass** der Bestückkopf (11) über das Ende des Führungsarms (9) hinaus auf das Längsführungsstück (14) verschiebbar ist.

2. Vorrichtung nach Anspruch 1,
**dadurch gekennzeichnet,**
**dass** zumindest ein z.B. als Rahmenteil (6) ausgebildeter stationärer Träger des Grundkörpers mit Lagerungselementen (20) zum lösbaren Anbringen eines Führungselementes (13, 13a, 13b) versehen ist, welches das Längsführungsstück (14) trägt.

3. Vorrichtung nach Anspruch 2,
**dadurch gekennzeichnet,**
**dass** das Führungselement (13, 13a, 13b) an seinem dem Führungsarm (9) zugewandten Ende in der Querrichtung (y) vom Bestückbereich weg gegen Vorspannung auslenkbar ist und
**dass** am Führungsarm (9) und am Führungselement (13, 13a, 13b) wechselseitige Anschläge derart angebracht sind, dass diese in der Abholstellung des Führungsarms (9) unter der Vorspannung aneinander liegen und dass dabei die Führungsbahnen des Führungsarms (9) und des Führungselements (13, 13a, 13b) zueinander fluchten.

4. Vorrichtung nach Anspruch 1, 2 oder 3,
**dadurch gekennzeichnet,**
**dass** das Substrat (2) in einem Bestückbereich der Vorrichtung fixierbar ist, dass Abholstellen (16) der Bauelemente entlang einer Längsseite des Bestückbereichs in der Längsrichtung (x) aneinander gereiht sind,
**dass** der Bestückkopf (11) zwischen dem Bestückbereich und den Abholstellen (16) verfahrbar ist und
**dass** im Zugriffsbereich des sich am Führungselement (13, 13a, 13b) befindenden Bestückkopfs (11) weitere Abholstellen (16) für die Bauelemente angeordnet sind.

5. Vorrichtung nach einem der Ansprüche 1 bis 4,
**dadurch gekennzeichnet,**
**dass** der Bestückkopf (11) am Führungsarm (9) mittels eines Linearmotors verschiebbar ist, dessen aktives Spulenteil mit dem Bestückkopf (11) verbunden ist und dessen Magnetteile (12) fluchtend am Führungsarm (9) und am Führungselement (13, 13a, 13b) angebracht sind.

6. Vorrichtung nach einem der Ansprüche 1 bis 5,
**dadurch gekennzeichnet,**
**dass** der z.B. als Rahmenteil (6) ausgebildete Träger Bestandteil des Grundkörpers (3) ist, an dem das Führungselement (13) unmittelbar gelagert ist.

7. Vorrichtung nach einem der Ansprüche 4 bis 6,
**dadurch gekennzeichnet,**
**dass** die in der Längsrichtung (x) aneinander gereihten Abholstellen (16) und die weiteren Abholstellen (16) an einer entsprechend langen Bereitstelleinrichtung (5) angeordnet sind.

8. Vorrichtung nach Anspruch 7,
**dadurch gekennzeichnet,**
**dass** die Abholstellen (16) und die weiteren Abholstellen (16) auf mehreren verkürzten Bereitstelleinrichtungen (5a) angeordnet sind, die nebeneinander mittel- oder unmittelbar am Grundkörper (3) bzw. am Trägerteil fixierbar sind.

9. Vorrichtung nach Anspruch 7 oder 8,
**dadurch gekennzeichnet,**
**dass** die Abholstellen (16) an schmalen in der Längsrichtung (x) aneinandergereihten Zuführmodulen (15) angeordnet sind, die an der Bereitstelleinrichtung (5, 5a) fixierbar sind.

10. Vorrichtung nach einem der vorhergehenden Ansprüche,
**dadurch gekennzeichnet,**
**dass** die Führungselemente (13, 13a, 13b) zu beiden Stirnseiten des in der Abholstellung befindlichen Führungsarms (9) angebracht sind und
**dass** der Führungsarm (9) zwischen seinen beiden stirnseitigen Enden eine durchgehende lineare Längsführung (10) aufweist.

11. Vorrichtung nach einem der vorhergehenden Ansprüche,
**dadurch gekennzeichnet,**
**dass** die Abholstellen (16) auf der dem Bestückbereich abgewandten Außenseite des Führungselements (13, 13a, 13b) angeordnet sind und dass eine den Abholstellen (16) zugewandte Außenseite des Führungsarms (9) durchgehend geradlinig verläuft.

12. Vorrichtung nach einem der vorhergehenden Ansprüche,
**dadurch gekennzeichnet,**
**dass** auf der den Abholstellen (16) gegenüberliegenden Seite des Bestückbereichs zusätzliche Abholstellen (16) angeordnet sind.

13. Vorrichtung nach Anspruch 12,
**dadurch gekennzeichnet,**
**dass** die Vorrichtung einen zusätzlichen am Grundkörper (3) in der Querrichtung (y) verschiebbaren Führungsarm (9) aufweist, an dem ein zusätzlicher Bestückkopf (11) in der Längsrichtung (x) verfahrbar ist, der auf der den zusätzlichen Abholstellen (16) zugewandten Seite des zusätzlichen Führungsarms (9) angeordnet ist.

14. Vorrichtung nach Anspruch 12 oder 13,
**dadurch gekennzeichnet,**
**dass** auf der den zusätzlichen Abholstellen (16) zugewandten Seite des Bestückbereichs mindestens ein weiteres zusätzliches Führungselement (13, 13a, 13b) angeordnet ist.

15. Vorrichtung nach einem der einem der vorhergehenden Ansprüche.
**dadurch gekennzeichnet,**
**dass** am Grundkörper (3) ein angesetztes Trägerteil (22a, 22b) lösbar befestigt ist, an dem ein entsprechend verlängertes Führungselement (13a, 13b) gelagert ist.

16. Vorrichtung nach einem der vorhergehenden Ansprüche,
**dadurch gekennzeichnet,**
**dass** der Bestückkopf (11) mit zumindest einem Greifer für eines der Bauelemente versehen ist und dass der Greifer am Bestückkopf (11), in der Querrichtung (y) bewegbar gelagert ist.

17. Vorrichtung nach Anspruch 16,
**dadurch gekennzeichnet,**
**dass** der Führungsarm (9) mit dem daran verbleibenden Bestückkopf (11) kurz vor dem Erreichen der Anschlagstellung am Führungselement (13, 13a, 13b) stoppbar ist.

18. Vorrichtung nach einem der vorhergehenden Ansprüche,
**dadurch gekennzeichnet,**
**dass** der Bestückkopf (11) mittels eines aerostatischen Lagers an dem Führungselement (13, 13a, 13b) bzw. dem Führungsarm (9) geführt ist.

19. Vorrichtung nach einem der vorhergehenden Ansprüche,
**dadurch gekennzeichnet,**
**dass** mindestens eine Teilmenge der Bauelemente in mindestens einem Flächenmagazin bereitstellbar und in der Querrichtung (y) in den Zugriffsbereich des Bestückkopfs (11) verschiebbar ist.

20. Vorrichtung nach einem der vorhergehenden Ansprüche,
**dadurch gekennzeichnet,**
**dass** eine weitere Vorrichtung gleichen Typs querseitig an der ersten Vorrichtung in der Längsrichtung (x) fluchtend ansetzbar ist und
**dass** die Abholstellen (16) der Bereitstelleinrichtungen (5a) durchgehend über beide Vorrichtungen erstreckbar sind, derart,dass die Bestückköpfe (11) beider Vorrichtungen auf die im mittleren Erstreckungsbereich angeordneten Abholstellen (16) zugreifen können.

## Claims

1. An apparatus for fitting a substrate (2) with electrical components, comprising at least one fitting head (11) for handling the components, wherein the substrate (2) can be fixed in position in a fitting area of the apparatus,
wherein the fitting head (11) can be moved in a linear rail-like longitudinal guide (10) of a guide arm (9) which can be moved in transverse direction (y) on a base body (3) of the apparatus,
**characterized in**
**that** the guide arm (9) can be moved to a defined stop position,
**that** at least one longitudinal guide part (14) of the same type for the fitting head (11) and aligned with the rail-like longitudinal guide (10) is directly attached to the base body or to a carrier part mounted to the base body in the aligned linear extension of the longitudinal guide (10) of the guide arm (9) when the latter is in its stop position and
**that** the fitting head (11) can be moved onto the longitudinal guide part (14) beyond the end of the guide arm (9).

2. The apparatus according to claim 1,
**characterized in that**
at least one stationary carrier of the base body (3) that is, for example, formed as a frame part (6) is provided with support elements (20) for attaching a guide element (13, 13a, 13b) in a detachable manner which holds the longitudinal guide part (14).

3. The apparatus according to claim 2,
**characterized in**
**that** at its end facing the guide arm (9), the guide element (13, 13a, 13b) can be swung out away from the fitting area in transverse direction (y) and against pretension and
**that** mutual stops are attached to the guide arm (9) and the guide element (13, 13a 13b) such that, when the guide arm (9) is in its collection position, said stops rest against each other under said pretension and that, therein, the guideways of the guide arm (9) and the guide element (13, 13a, 13b) are aligned with each other.

4. The apparatus according to claim 1, 2 or 3,
**characterized in**
**that** the substrate (2) can be fixed in position in a fitting area of the apparatus,
**that** collection sites (16) of the components are placed side by side in longitudinal direction (x) along a longitudinal side of the fitting area,
**that** the fitting head (11) can be traversed between the fitting area and the collection sites (16) and
**that** further collection sites (16) for the components are arranged in the access area of the fitting head (11) that is disposed on the guide element (13, 13a, 13b).

5. The apparatus according to any one of claims 1 to 4,
**characterized in that**
the fitting head (11) can be moved on the guide arm (9) by means of a linear motor, the active coil part of which is connected to the fitting head (11) and the magnet parts (12) of which are attached to the guide arm (9) and to the guide element (13, 13a, 13b) in an aligned manner.

6. The apparatus according to any one of claims 1 to 5,
**characterized in that**
the carrier that is, for example, formed as a frame part (6) is an integral part of the base body (3) to which the guide element (13) is directly mounted.

7. The apparatus according to any one of claims 4 to 6,
**characterized in that**
the collection sites (16) that are placed side by side in longitudinal direction (x) and the further collection sites (16) are arranged on a providing device (5) that is correspondingly long.

8. The apparatus according to claim 7,
**characterized in that**
the collection sites (16) and the further collection sites (16) are arranged on a plurality of shortened providing devices (5a) that can be fixed side by side in position on the base body (3) or the carrier part either indirectly or directly.

9. The apparatus according to claim 7 or 8,
**characterized in that**
the collection sites (16) are arranged on narrow supply modules (15) that are placed side by side in longitudinal direction (x) and can be fixed in position on the providing device (5, 5a).

10. The apparatus according to any one of the preceding claims, **characterized in**
**that** the guide elements (13, 13a, 13b) are attached at both front faces of the guide arm (9) when the latter is in its collection position and
**that** the guide arm (9) comprises a continuous linear longitudinal guide (10) between its two ends on the front face.

11. The apparatus according to any one of the preceding claims, **characterized in**
**that** the collection sites (16) are arranged on the outer face of the guide element (13, 13a, 13b) that is facing away from the fitting area and that an outer face of the guide arm (9) that is facing the collection sites (16) continuously extends in a straight line.

12. The apparatus according to any one of the preceding claims, **characterized in that**
additional collection sites (16) are arranged on the side of the fitting area that is disposed opposite to the collection sites (16).

13. The apparatus according to claim 12,
**characterized in that**
the apparatus comprises an additional guide arm (9) that can be moved in transverse direction (y) on the base body (3) and on which an additional fitting head (11) can be traversed in longitudinal direction (x), said fitting head (11) being arranged on the side of the additional guide arm (9) facing the additional collection sides (16).

14. The apparatus according to claim 12 or 13,
**characterized in that**
at least one further additional guide element (13, 13a, 13b) is arranged on the side of the fitting area facing the additional collection sides (16).

15. The apparatus according to any one of the preceding claims, **characterized in that**
an attached carrier part (22a, 22b) is mounted to the base body (3) in a detachable manner, with a correspondingly extended guide element (13a, 13b) being mounted to said carrier part (22a, 22b).

16. The apparatus according to any one of the preceding claims, **characterized in**
**that** the fitting head (11) is provided with at least one gripper for one of the components and that the gripper is mounted to the fitting head (11) such that it can be moved in transverse direction (y).

17. The apparatus according to claim 16,
**characterized in that**
the guide arm (9) including the fitting head (11) remaining thereon can be stopped shortly before the stop position on the guide element (13, 13a, 13b) is reached.

18. The apparatus according to any one of the preceding claims, **characterized in that**
the fitting head (11) is guided by means of an aerostatic bearing on the guide element (13, 13a, 13b) or the guide arm (9).

19. The apparatus according to any one of the preceding claims, **characterized in that**
at least one subset of the components can be provided in at least one area magazine and can be moved to the access area of the fitting head (11) in transverse direction (y).

20. The apparatus according to any one of the preceding claims, **characterized in**
**that** a further apparatus of the same type can be attached to the first apparatus on a transverse side in longitudinal direction (x) and in an aligned manner and
**that** the collection sites (16) of the providing devices (5a) can be extended continuously across both apparatuses such that the fitting heads (11) of both apparatuses can access the collection sites (16) arranged in the central extension region.

## Revendications

1. Dispositif pour monter des composants électriques sur un substrat (2), avec une tête de montage (11) pour manipuler les composants,
étant précisé que le substrat (2) est apte à être fixé dans une zone de montage du dispositif,
que la tête de montage (11) est apte à coulisser dans un guide longitudinal linéaire en forme de rail (10) d'un bras de guidage (9) qui est apte à coulisser dans un sens transversal (y) sur un corps de base (3) du dispositif, **caractérisé**
**en ce que** le bras de guidage (9) est apte à coulisser jusqu'à une position d'arrêt définie,
**en ce que** dans le prolongement linéaire, dans l'alignement, du guide longitudinal (10) du bras de guidage (9) qui se trouve en position d'arrêt, au moins un élément de guide longitudinal (14) de même type, dans l'alignement dudit guide longitudinal linéaire en forme de rail (10), pour la tête de montage (11) est fixé directement au corps de base ou à un élément de support en appui sur le corps de base, et
**en ce que** la tête de montage (11) est apte à coulisser, au-delà de l'extrémité du bras de guidage (9), jusque sur l'élément de guide longitudinal (14).

2. Dispositif selon la revendication 1,
**caractérisé**
**en ce qu'**au moins un support stationnaire du corps de base, conçu par exemple comme un élément formant cadre (6), est pourvu d'éléments d'appui .(20) pour l'installation amovible d'un élément de guidage (13, 13a, 13b) qui porte l'élément de guide longitudinal (14).

3. Dispositif selon la revendication 2,
**caractérisé**
**en ce que** l'élément de guidage (13, 13a, 13b), à son extrémité tournée vers le bras de guidage (9), est apte à être dévié dans le sens transversal (y), à l'encontre d'une pré-tension, pour être éloigné de la zone de montage, et
**en ce que** sur le bras de guidage (9) et sur l'élément de guidage (13, 13a, 13b), des butées mutuelles sont installées de telle sorte que lesdites butées, dans la position de collecte du bras de guidage (9), soient appliquées l'une contre l'autre sous l'effet de la prétension et que les guides du bras de guidage (9) et de l'élément de guidage (13, 13a, 13b) soient dans l'alignement.

4. Dispositif selon la revendication 1, 2 ou 3, **caractérisé**
**en ce que** le substrat (2) est apte à être fixé dans une zone de montage,
**en ce que** des points de collecte (16) des composants sont placés à la suite les uns des autres le long d'un côté longitudinal de la zone de montage, dans le sens longitudinal (x),
**en ce que** la tête de montage (11) est mobile entre la zone de montage et les points de collecte (16), et
**en ce qu'**il est prévu, dans la zone d'accès de la tête de montage (11) qui se trouve sur l'élément de guidage (13, 13a, 13b), d'autres points de collecte (16) pour les composants.

5. Dispositif selon l'une des revendications 1 à 4, **caractérisé**
**en ce que** la tête de montage (11) est apte à coulisser sur le bras de guidage (9) à l'aide d'un moteur linéaire dont l'élément actif formant bobine est relié à la tête de montage (11) et dont les éléments formant aimants (12) sont installés dans l'alignement sur le bras de guidage (9) et sur l'élément de guidage (13, 13a, 13b).

6. Dispositif selon l'une des revendications 1 à 5, **caractérisé**
**en ce que** le support conçu par exemple comme un élément formant cadre (6) fait partie du corps de base (3) sur lequel l'élément de guidage (13) est directement en appui.

7. Dispositif selon l'une des revendications 4 à 6, **caractérisé**
**en ce que** les points de collecte (16) placés à la suite les uns des autres dans le sens longitudinal (x) et les autres points de collecte (16) sont disposés dans un dispositif de réserve (5) d'une longueur correspondante.

8. Dispositif selon la revendication 7,
**caractérisé**
**en ce que** les points de collecte (16) et les autres points de collecte (16) sont disposés sur plusieurs dispositifs de réserve raccourcis (5a) qui sont aptes à être fixés côte à côte au corps de base (3) ou à l'élément de support, directement ou indirectement.

9. Dispositif selon la revendication 7 ou 8, **caractérisé**
**en ce que** les points de collecte (16) sont disposés sur des modules d'amenée (15) étroits, placés à la suite les uns des autres dans le sens longitudinal (x), qui sont aptes à être fixés au dispositif de réserve (5, 5a).

10. Dispositif selon l'une des revendications précédentes,
**caractérisé**
**en ce que** les éléments de guidage (13, 13a, 13b) sont installés des deux côtés du bras de guidage (9) qui se trouvent en position de collecte, et
**en ce que** le bras de guidage (9) comporte, entre ses deux extrémités situées côté frontal, un guide longitudinal linéaire (10) continu.

11. Dispositif selon l'une des revendications précédentes,
**caractérisé**
**en ce que** les points de collecte (16) sont disposés sur le côté extérieur, opposé à la zone de montage, de l'élément de guidage (13, 13a, 13), et en ce qu'un côté extérieur, tourné vers les points de collecte (16), du bras de guidage (9) s'étend en ligne droite de manière continue.

12. Dispositif selon l'une des revendications précédentes,
**caractérisé**
**en ce qu'**il est prévu, sur le côté de la zone de montage situé en face des points de collecte, des points de collecte (16) supplémentaires.

13. Dispositif selon la revendication 12,
**caractérisé**
**en ce que** le dispositif comporte un bras de guidage (9) supplémentaire qui est apte à coulisser sur le corps de base (3) dans le sens transversal (y) et sur lequel est mobile dans le sens longitudinal (x) une tête de montage (11) supplémentaire qui est disposée sur le côté du bras de guidage (9) supplémentaire tourné vers les points de collecte (16) supplémentaires.

14. Dispositif selon la revendication 12 ou 13, **caractérisé**
**en ce qu'**il est prévu, sur le côté de la zone de montage tourné vers les points de collecte (16) supplémentaires, au moins un autre élément de guidage (13, 13a, 13b) supplémentaire.

15. Dispositif selon l'une des revendications précédentes,
**caractérisé**
**en ce qu'**il est prévu, fixé de manière amovible au corps de base (3), un élément de support rapporté (22a, 22b) sur lequel un élément de guidage (13a, 13b) prolongé en conséquence est en appui.

16. Dispositif selon l'une des revendications précédentes,
**caractérisé**
**en ce que** la tête de montage (11) est pourvue d'au moins un organe de préhension pour l'un des composants, et en ce que l'organe de préhension est installé sur la tête de montage (11) de manière à être mobile dans le sens transversal (y).

17. Dispositif selon la revendication 16,
**caractérisé**
**en ce que** le bras de guidage (9), avec la tête de montage (11) restée sur lui, est apte à être arrêté juste avant d'atteindre la position de butée contre l'élément de guidage (13, 13a, 13b).

18. Dispositif selon l'une des revendications précédentes,
**caractérisé**
**en ce que** la tête de montage (11) est guidée à l'aide d'un palier aérostatique sur l'élément de guidage (13, 13a, 13b) ou sur le bras de guidage (9).

19. Dispositif selon l'une des revendications précédentes,
**caractérisé**
**en ce qu'**une partie au moins des composants sont aptes à être réservés dans au moins un magasin de surface et sont aptes à coulisser dans le sens transversal (y) jusque dans la zone d'accès de la tête de montage (11).

20. Dispositif selon l'une des revendications précédentes,
**caractérisé**
**en ce qu'**un autre dispositif du même type est apte à être rapporté côté transversal, dans l'alignement dans le sens longitudinal (x), sur le premier dispositif, et
**en ce que** les points de collecte (16) des dispositifs de réserve (5a) sont aptes à s'étendre de manière continue sur les deux dispositifs, de telle sorte que les têtes de montage (11) des deux dispositifs peuvent accéder aux points de collecte (16) disposés dans la zone d'extension centrale.
